# EUROPEAN PATENT SPECIFICATION

(11) **EP 1 491 950 B1**
(45) Date of publication and mention of the grant of the patent: **09.11.2011**
(21) Application number: 03014140.2
(22) Date of filing: 24.06.2003
(51) Int. Cl.: G03F 7/00, B81B 3/00

(54) **Micro device and process for producing it**
Mikrobauteil und Verfahren zu seiner Herstellung
Microdispositif et procédé pour sa fabrication

(43) Date of publication of application: 29.12.2004
(73) Proprietor: NanoWorld AG, 2007 Neuchâtel (CH)
(72) Inventor: Detterbeck, Manfred, 2000 Neuchâtel (CH); Lutter, Stefan, 2000 Neuchâtel (CH); Burri, Mathieu, 2738 Court (CH); Hartmann, Theo, 90443 Nürnberg (DE); Akiyama, Terunobu, 2000 Neuchâtel (CH)
(74) Representative: Klocke, Peter

(56) References cited:
- CONRADIE E H ET AL: "SU-8 thick photoresist processing as a functional material for MEMS applications" 12TH MICROMECHANICS EUROPE WORKSHOP (MME'01), CORK, IRELAND, 16-18 SEPT. 2001, vol. 12, no. 4, pages 368-374, XP002266218 Journal of Micromechanics and Microengineering, July 2002, IOP Publishing, UK ISSN: 0960-1317
- LIGER M ET AL: "Robust parylene-to-silicon mechanical anchoring" PROCEEDINGS IEEE SIXTEENTH ANNUAL INTERNATIONAL CONFERENCE ON MICRO ELECTRO MECHANICAL SYSTEMS (CAT. NO.03CH37426), PROCEEDINGS IEEE SIXTEENTH ANNUAL INTERNATIONAL CONFERENCE ON MICRO ELECTRO MECHANICAL SYSTEMS, KYOTO, JAPAN, 19-23 JAN. 2003, pages 602-605, XP002266219 2003, Piscataway, NJ, USA, IEEE, USA ISBN: 0-7803-7744-3
- PATENT ABSTRACTS OF JAPAN vol. 1997, no. 12, 25 December 1997 (1997-12-25) & JP 09 205271 A (IBIDEN CO LTD), 5 August 1997 (1997-08-05)

## Description

The present invention relates to micro devices and to a process for producing micro devices of this type.

Micro devices are understood as devices belonging to the general field of Micro Electro Mechanical Systems (MEMS), which includes microelectronics (coils, capacitors, dielectric material), micromechanics (sensors, fast prototyping, biochips), microfluidics (Micro Total Analysis Systems (µTAS) (applications of miniaturized chemical, biochemical and biological systems; micro and nano-scale technologies related to analytical systems, synthesis of compounds, clinical diagnostics, genomics, drug screening, and combinatorial chemistry), micropumps,) and even more.

MEMS industry uses more and more often SU-8 photoresist to define structures on a chip in view of its significant advantages. The SU-8 is a negative, epoxy-type, near-UV photoresist commercially available under this trade name. This photoresist can be as thick as 2 mm and an aspect ratio better than 20 can be achieved with standard contact lithography equipment. That makes it possible to define a significant number of varied structures, which are impossible to realize with other materials. Moreover, it has a very high optical transparency above 360 nm and is thermally stable.

One of the biggest problems of SU-8 photoresist is its adhesion on the layer below. This adhesion depends on the material (of the layer below) but is really affected by the chemical environment. For example, SU-8 delaminates from many surfaces when immersed in KOH (Potassium Hydroxide solution) or TMAH (Tetra Methyl Ammonium Hydroxide solution), whereas it withstands HF (hydrofluoric acid). There are some solutions to improve the adhesion of the SU-8, but none could avoid the lift-off in long KOH or TMAH wet-etching so far.

Therefore, the present invention is based on the object of proposing a solution to avoid the SU-8 lift-off during a KOH or TMAH treatment. According to the invention, this object is achieved by a micro device having the features of claim 1 and a process having the features of independent process claim. Further advantageous configurations are to be found in the subclaims, which refer back to these claims.

The general idea of the present invention is to clamp the SU-8 photoresist layer on a thin layer below (e.g. silicon nitride, silicon oxide, metal, diamond). Thus, the micro device for micro electro mechanical systems comprises at least one layer of SU-8 photoresist, which is adhered to a clamping layer with through holes. The through holes in the clamping layer are filled with SU-8 photoresist and are covered on both sides with SU-8 photoresist at least adjacent the holes. On the first (upper) side the through holes are covered by the SU-8 photoresist layer and on the second (back) side preferably only by SU-8 in a small region having a diameter larger than the diameter of the through holes for obtaining the clamping effect at the clamping layer. In such a device, which can comprise several micro electro mechanical elements as discussed above, these devices are fixed via SU-8 photoresist. The clamping layer also may have further functions, which are important for the final device. For example, the clamping layer serves as a cantilever that bears a tip at the end and forms together with the SU-8 photoresist layer on the upper side a sensor for a Scanning Probe Microscope (SPM). In such a case, the SU-8 photoresist forms the holding element. The SU-8 photoresist on the backside surrounding the through holes provides a rim, which makes impossible for the SU-8 to lift off during a subsequent wet-etching KOH or TMAH step. These micro devices normally are produced from a wafer and are, when completed, fixed to a frame for transport and breaking off from the frame when needed.

The process according to the present invention for producing such a micro device comprises providing a clamping layer on a silicon substrate (comprising micro electro mechanical elements), transferring of at least a matrix of hole structures into the clamping layer by etching of through holes into said clamping layer, under-etching of the remaining parts of the clamping layer, coating the surface of the clamping layer and the through holes including the under-etched areas of the clamping layer by applying of SU-8 photoresist. The clamping layer may be of the material mentioned above having a thickness depending on the functions that have to be fulfilled by this layer for the MEMS. A common thickness is in the range of 10 nm to 10 *µ*m. After the application of the clamping layer, the damping layer is opened by well-known etching methods for defining the design of the clamping layer and a matrix of through holes in this layer. The matrix period and the holes diameter depend of the design of the layer, e.g. period 100 µm, diameter 50-80 µm. Next, the layer below the clamping layer is also etched in order to obtain an under-etching of the clamping layer. This step depends on the material under the clamping layer. It is possible to apply the clamping layer directly on the substrate or, on an interlayer between the damping layer and the substrate in cases, which need for the function of the MEMS such an interlayer. After under-etching, SU-8 is coated with a normal spinner tool upon the surface of the clamping layer and the holes. Finally, it is possible, according to the requirements of the MEMS to remove all the silicon, which is not further necessary, except the silicon frame holding the single micro devices for removing from the frame when needed.

In the case that SU-8 is not able to go under the clamping layer, it is possible to coat two different SU-8 formulations: Thus, according to an embodiment of the invention the process further comprises applying a first SU-8 formulation being very liquid and being able to reach the under-etched areas, followed by a second SU-8 formulation being capable to define the required structures. The adhesion between two SU-8 layers is generally very good.

According to one embodiment of the invention, the process comprises dry-etching of the clamping layer for providing the through holes, and etching of the silicon substrate in a way that the clamping layer is under-etched.

According to a preferred embodiment of the invention the process comprises providing an interlayer under the clamping layer, wherein the two layers are of different materials, preferably selected from one of the group of silicon compounds, metal or metal compounds or a combination thereof. Etching of the clamping layer performs the forming of the design and the matrix of through holes in the clamping layer. The following wet over-etching of the interlayer permits to create an under-etching of the clamping layer. The viscosity of SU-8 and the thickness of the interlayer define, if a deeper under-etching of the clamping layer is necessary or not. In case that SU-8 is not liquid enough to flow under the clamping layer after the over-etching of interlayer, the silicon substrate is wet-etched.

Preferably the process comprises finally removing of the silicon substrate as far as it is not further necessary from the backside and, if existing accessible, removing of the interlayer.

In the following the invention is explained in more detail below with reference to exemplary embodiments shown in the figures, in which:
- Figures 1-6: show cross-sectional illustrations of the process for producing a micro device of this type for forming a micro device;
- Figures 7-8: show sectional illustrations of a hybrid sensor SPM sensor assembly as an embodiment of the structures depicted in figures 1 to 6; and
- Figure 9: shows a plan view of an SPM sensor with improved adhesion between the cantilever layer material and the holding element according to the invention.

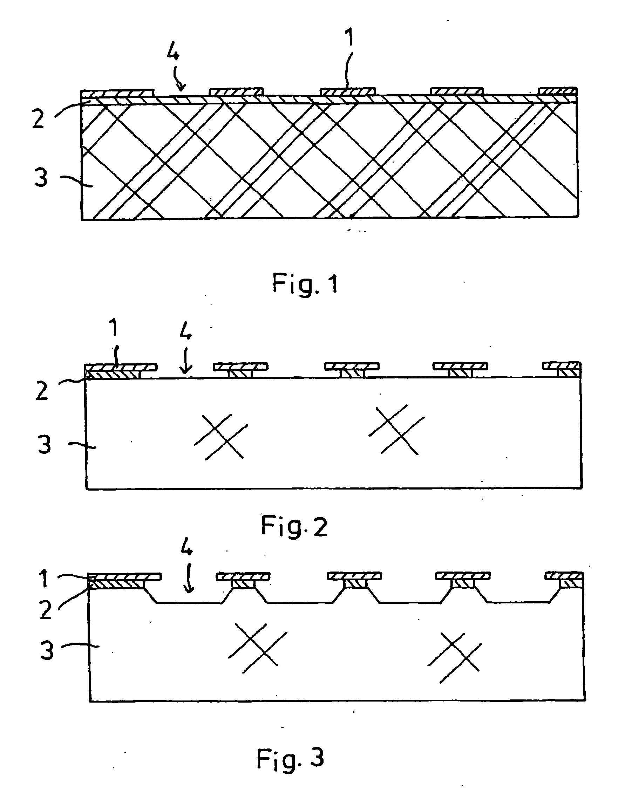

Figure 1 shows a silicon substrate 3 with a clamping layer 1 and an interlayer 2 between substrate 3 and clamping layer 1. The clamping layer 1 is in this embodiment of silicon nitride and the interlayer is of silicon oxide. The clamping layer 1 is already opened by a well-known dry-etching process forming holes 4 into the surface of the clamping layer 1.

In figure 2 the interlayer 2 is wet over-etched thereby providing an under-etching of the clamping layer 1.

Next, the silicon is wet-etched with KOH as shown in figure 3. This step is only necessary, as mentioned above, if SU-8 is not liquid enough to flow under the clamping layer 1.

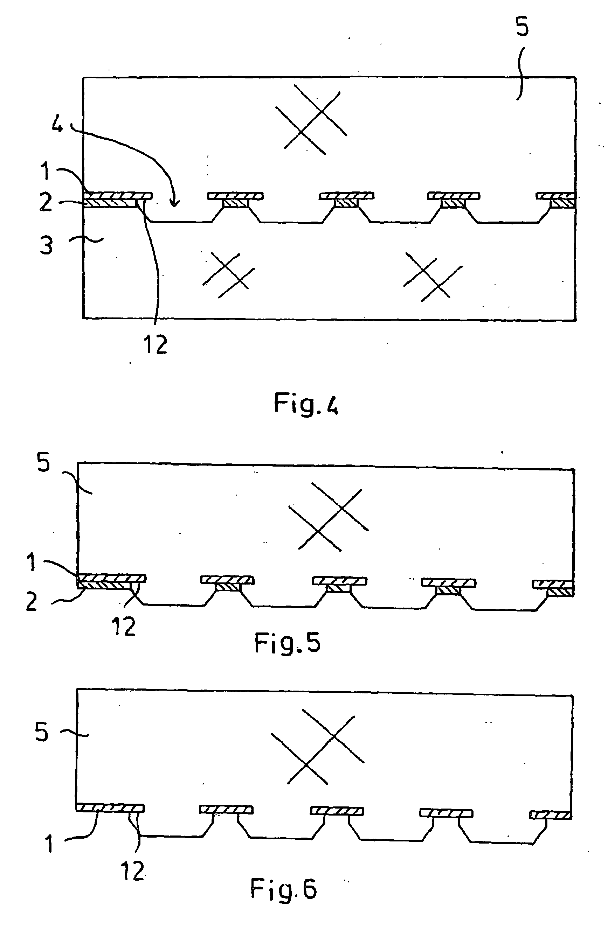

Figure 4 shows the structure of figure 3 coated with a SU-8 layer 5 thereby also filling the area under the clamping layer 1 and forming a rim 12, which prevents moving of SU-8 in the vertical direction.

The final steps are shown in figures 5 and 6 in which the silicon substrate 3 is wet-etched by KOH and then the interlayer 2 made of silicon oxide is removed by a buffered hydrofluoric acid (BHF).

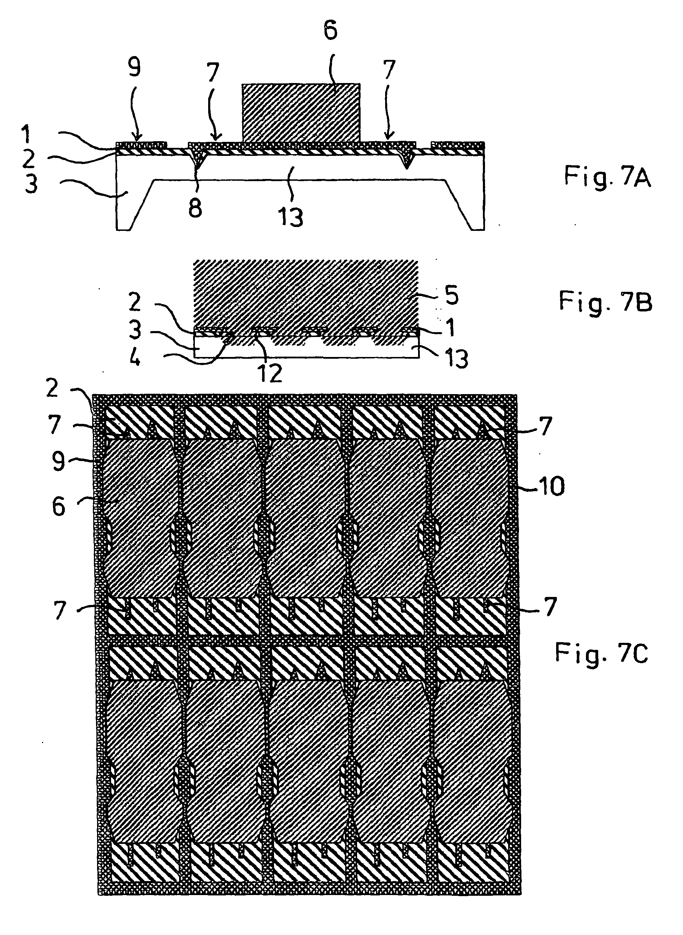

Figure 7 shows the situation according to figure 4 with the SU-8 layer 5 applied to the entire wafer (substrate (Si)) in order to form a SPM sensor with a holding element 6 made of SU-8 and a cantilever 7 with a tip 8 at the end. The cantilever 7 and the tip 8 are made of material of the clamping layer 1 (SiN). The interlayer 2 (SiO₂) is used for forming and sharpening the tip 8. The layer 5 is photolithographically patterned in the usual way to form the holding element 6. Figure 7A shows the cross-sectional view of the holding element 6 on the clamping layer 1 forming two cantilevers 7 with tips 8. The interlayer 2 is shown between the clamping layer 1 and the membrane 13 of the substrate 3. Figure 7B shows the excerpt-enlargement of the SU-8 layer 5 on the clamping layer 1 with the holes 4 and the membrane 13 according to figure 4. Figure 7C shows the top view on a silicon frame 9 with the holders 10 and holding elements 6 with four cantilevers 7. The cantilevers have different shapes (triangular and rectangular) and different lengths. Each cantilever has a tip at its end. This allows the customer to decide which cantilever he wants to use. In this embodiment the holders 10 for fixing the micro device (SPM sensor) to the frame 9 are included in the holding element 6.

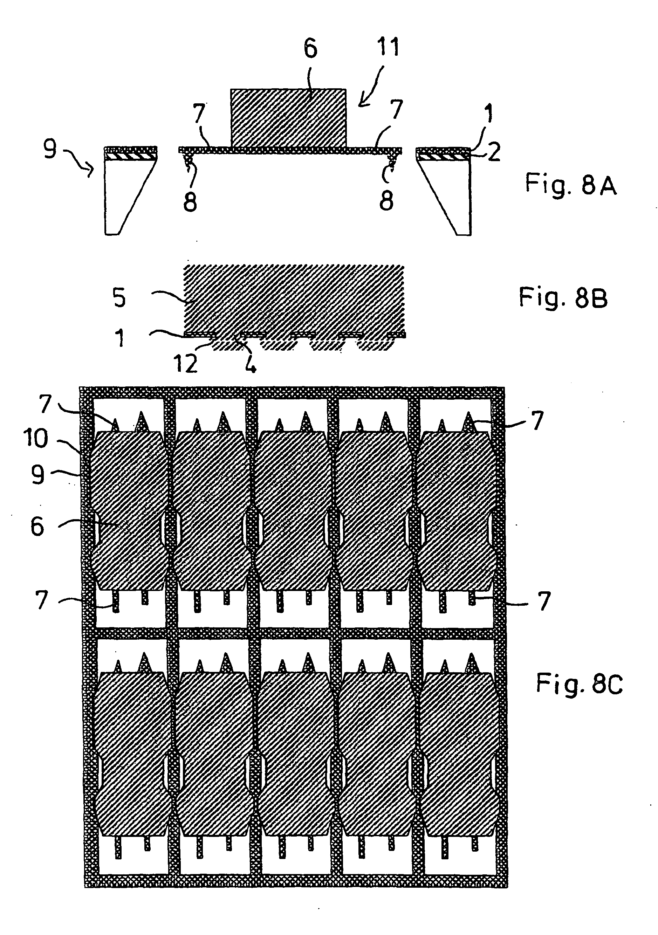

For obtaining the SPM sensor 11 with the holding element 6 made of SU-8, the cantilever 7 and the tip 8 the silicon substrate 3 is etched from the backside of the substrate 3 (in KOH) until the silicon membrane 13 is open (according to figure 5). The finished SPM sensor (figure 8A) is then obtained by removal of the interlayer 2, which is used as a sacrificial layer, in this case made of silicon oxide, by means of BHF. Figure 8B shows the respective excerpt-enlargement according to figure 6. Figure 8C shows for example a plan view of the finished frame 9 with the holders 10 and the SPM sensors located therein in plan view, illustrating the holding element 6, and, for example, also the frame 9 and the holders 10 included in the holding element 6, as it can be sold.

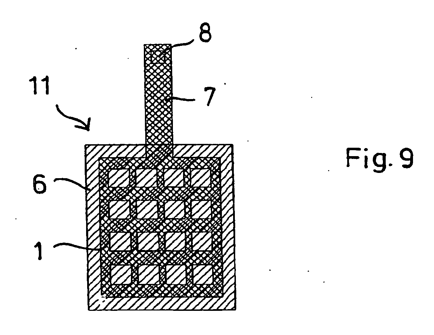

Figure 9 finally shows a SPM sensor with the holding element 6, the cantilever 7 and the tip 8 with the clamping layer 1 having holes 4 with the SU-8 forming a rim 12 as shown in figures 4 to 6 so that the SU-8 photoresist links to the silicon nitride as clamping layer 1 which also forms the cantilever 7.

## Claims

1. Micro device for micro electro mechanical systems, comprising at least one layer (5) of a SU-8 photoresist, a negative, epoxy-type, near-UV photoresist composition, which is adhered to a clamping layer (1) with through holes (4), said through holes (4) are filled with SU-8 photoresist and are covered on both sides with SU-8 photoresist at least adjacent the holes, wherein on one side SU-8 only covers a small region having a diameter larger than the diameter of the through holes (4) for obtaining the clamping effect.

2. Process for producing a micro device according to claim 1 comprising the follwing steps:
Providing a clamping layer (1) on a silicon substrate (3);
Transferring of at least a matrix of hole structures (4) into the clamping layer(1) by etching of through holes (4) into said clamping layer (1);
Under-etching of the remaining parts of the clamping layer (1);
Coating the surface of the clamping layer (1) and the through holes (4) including the under-etched areas of the clamping layer by applying of a SU-8 photoresist, a negative, epoxy-type, near-UV photoresist composition.

3. Process as claimed in claim 2 comprising applying a first resist composition formulation being very liquid and being able to reach the under-etched areas, followed by a second resist composition formulation being capable to define the required structures.

4. Process as claimed in claim 2 comprising etching of the clamping layer (1) for providing the through holes (4), etching of the silicon substrate (3) for transferring the structures of the clamping layer (1) into the substrate and subsequently under-etching the clamping layer.

5. Process as claimed in claim 2 comprising providing an interlayer (2) on the clamping layer (1), wherein the two layers are of different materials, preferably selected from one of the group of silicon compounds, metal or metal compounds or a combination thereof.

6. Process as claimed in claim 4 comprising etching of the clamping layer (1) followed a subsequently over-etching of the interlayer.

7. Process as claimed in claim 6 comprising etching of the silicon substrate, so that the clamping layer (1) is under-etched.

8. Process as claimed in one of the preceding claims comprising removing of the silicon substrate as far as it is not further necessary from the backside and, if existing accessible, removing of the interlayer.

## Patentansprüche

1. Mikrovorrichtung für mikroelektromechanische Systeme, mit mindestens einer Schicht (5) aus SU-8-Fotolack, eine negative epoxydartige und für Licht im nahem UV-Bereich undurchlässige Zusammensetzung, der an einer mit Durchgangslöchern (4) versehenen Befestigungsschicht (1) haftet, wobei die Durchgangslöcher (4) mit SU-8-Fotolack gefüllt sind und an beiden Seiten wenigstens angrenzend an die Durchgangslöcher (4) mit SU-8-Fotolack abgedeckt sind, und wobei der SU-8-Fotolack auf einer Seite nur einen geringen Bereich bedeckt, der einen gegenüber dem Durchmesser der Durchgangslöcher (4) größeren Durchmesser aufweist, um den Befestigungseffekt zu erreichen.

2. Verfahren zur Herstellung einer Mikrovorrichtung gemäß Anspruch 1, mit den folgenden Schritten:
- Bereitstellen einer Befestigungsschicht (1) auf einem SiliziumSubstrat (3);
- Übertragen von mindestens einer Lochstrukturmatrix auf die Befestigungsschicht (1) durch Ätzen von Durchganglöchern (4) in die Befestigungsschicht (1);
- Unterätzen der verbliebenen Teile der Befestigungsschicht (1);
- Beschichten der Oberseite der Befestigungsschicht (1) und der Durchgangslöcher (4) einschließlich der unterätzten Bereiche der Befestigungsschicht (1) durch Aufbringen eines SU-8-Fotolacks, eine negative epoxydartige für Licht im nahen UV-Bereich undurchlässige Zusammensetzung.

3. Verfahren nach Anspruch 2, **gekennzeichnet durch** Aufbringen einer ersten Lackschicht-Mischung, die dünnflüssig ist und die unterätzten Bereich erreichen kann, gefolgt von einer zweiten Lackschicht-Mischung, die geeignet ist, die erforderlichen Strukturen auszubilden.

4. Verfahren nach Anspruch 2, **gekennzeichnet durch** Ätzen der Befestigungsschicht (1) zum Erzeugen der Durchgangslöcher (4), Ätzen des Silizium-Substrats (3) zum Übertragen der Strukturen der Befestigungsschicht (1) in das Substrat und anschließendes Unterätzen der Befestigungsschicht.

5. Verfahren nach Anspruch 2, **gekennzeichnet durch** Bereitstellen einer Zwischenschicht (2) an der Befestigungsschicht (1), wobei die beiden Schichten aus unterschiedlichem Material sind, vorzugsweise ausgewählt aus einer der Gruppen Silizium-Verbindungen, Metalle oder MetallVerbindungen oder Kombinationen daraus.

6. Verfahren nach Anspruch 4, **gekennzeichnet durch** Ätzen der Befestigungsschicht (1) gefolgt von einem anschließenden Überätzen der Zwischenschicht.

7. Verfahren nach Anspruch 6, **gekennzeichnet durch** Ätzen des Silizium-Substrats derart, dass die Befestigungsschicht unterätzt ist.

8. Verfahren nach einem der vorstehenden Ansprüche, **gekennzeichnet durch** Entfernen des Silizium-Substrats von der Rückseite her, soweit es nicht weiter benötigt wird und gegebenenfalls Entfernen der Zwischenschicht soweit zugänglich.

## Revendications

1. Microdispositif destiné à des microsystèmes électromécaniques, comprenant au moins une couche (5) d'une résine photosensible SU-8, une composition de résine photosensible à un rayonnement ultraviolet proche, de type époxy, négative, qui est collée sur une couche de fixation (1) comportant des trous traversants (4), lesdits trous traversants (4) sont remplis d'une résine photosensible SU-8 et sont recouverts des deux côtés par la résine photosensible SU-8 au moins de façon adjacente aux trous, dans lequel sur un seul côté la résine SU-8 couvre uniquement une petite région ayant un diamètre plus important que le diamètre des trous traversants (4) en vue d'obtenir l'effet de fixation.

2. Procédé destiné à produire un microdispositif selon la revendication 1, comprenant les étapes suivantes :
la fourniture d'une couche de fixation (1) sur un substrat de silicium (3) ;
le transfert d'au moins une matrice des structures à trous (4) dans la couche de fixation (1) par la gravure de trous traversants (4) dans ladite couche de fixation (1) ;
la sous-gravure des parties restantes de la couche de fixation (1) ;
le recouvrement de la surface de la couche de fixation (1) et des trous traversants (4) y compris les zones sous-gravées de la couche de fixation par l'application d'une résine photosensible SU-8, une composition de résine photosensible au rayonnement ultraviolet proche, de type époxy, négative.

3. Procédé selon la revendication 2, comprenant l'application d'une première formulation de composition de résine sensible, qui est très liquide et est en mesure d'atteindre les zones sous-gravées, suivie d'une deuxième formulation de composition de résine sensible qui est en mesure de définir les structures requises.

4. Procédé selon la revendication 2, comprenant la gravure de la couche de fixation (1) en vue de ménager les trous traversants (4), la gravure du substrat de silicium (3) en vue de transférer les structures de la couche de fixation (1) dans le substrat et ultérieurement la sous- gravure de la couche de fixation.

5. Procédé selon la revendication 2, comprenant la disposition d'une couche intermédiaire (2) sur la couche de fixation (1), dans lequel les deux couches sont constituées de matériaux différents, sélectionnés de préférence à partir d'un élément parmi le groupe constitué de composés de silicium, de métal, ou de composés métalliques ou d'une combinaison de ceux-ci.

6. Procédé selon la revendication 4, comprenant la gravure de la couche de fixation (1) suivie d'une sur- gravure ultérieure de la couche intermédiaire.

7. Procédé selon la revendication 6, comprenant la gravure du substrat de silicium, de sorte que la couche de fixation (1) soit sous-gravée.

8. Procédé selon l'une des revendications précédentes, comprenant le retrait du substrat de silicium, jusqu'à ce que cela ne soit plus nécessaire, du verso, et, s'il existe un accès possible, le retrait de la couche intermédiaire.
